# EUROPEAN PATENT APPLICATION

(11) **EP 2 493 271 A1**
(43) Date of publication of application: **29.08.2012**
(21) Application number: 10825074.7
(22) Date of filing: 18.10.2010
(51) Int. Cl.: H05B 33/22, H01L 51/50, H05B 33/10, H05B 33/12

(54) **SUBSTRATE FOR ORGANIC ELECTROLUMINESCENCE DEVICE AND METHOD OF MANUFACTURING ORGANIC ELECTROLUMINESCENCE DEVICE EMPLOYING SAME**

(30) Priority: 22.10.2009 JP 2009243842
(71) Applicant: Sumitomo Chemical Company, Limited, Tokyo 104-8260 (JP)
(72) Inventor: FURIHATA, Masatoshi, Niihama-shi Ehime 792-0025 (JP); AMAMIYA, Satoshi, Niihama-shi Ehime 792-0025 (JP)
(74) Representative: Jackson, Martin Peter
(86) International application number: PCT/JP2010/068781
(87) International publication number: WO 2011/049225

(57) **Abstract**

The present invention provides a substrate for an organic EL device. The substrate for an organic EL device of the present invention is provided with a support substrate on which a plurality of pixel electrode arrays are formed in parallel with each other, and a partition wall composed of stripe partition walls located between each of the pixel electrode arrays along the pixel electrode arrays and a frame partition wall in the form of a rectangle surrounding all of the plurality of pixel electrode arrays, and in this structure, the partition wall partitions a coating area of ink applied on the pixel electrode arrays and a neighboring coating area of ink applied on the pixel electrode array, and notches are located in the stripe partition walls to make the neighboring coating areas communicate with each other.

## Description

### TECHNICAL FIELD

The invention relates to a substrate for an organic electroluminescence (hereinafter, referred to as "organic EL") device in which a partition wall that partitions pixels is formed on a support substrate, which is used for manufacturing organic EL devices, and also relates to a method for manufacturing an organic EL device using such a substrate.

### BACKGROUND ART

Organic EL devices have already been put into practical use as devices for use in portable telephones and the like. The organic EL device includes an organic EL element made of a laminated article having an anode and a cathode and one or more organic EL layers including a light emitting layer sandwiched between these electrodes. The light emitting layer is made from an organic compound that emits light when, upon application of a voltage thereto, a current flows therethrough. The organic EL element has various characteristics. The organic EL element is formed by stacking thin films. By using the organic EL element, an apparatus such as a display apparatus can be made into an extremely thin form.

The organic EL element is normally manufactured by stacking, in a prescribed order, electrodes and one or more organic EL layers including a light emitting layer on a substrate for an organic EL device in which a partition wall that partitions pixels is formed on a support substrate. The organic EL device includes a large number of organic EL elements that are arranged therein.

In the organic EL device that has already been put into practical use, an organic EL layer for each organic EL element is formed by a vacuum vapor deposition method in which a mask is used. In this case, however, because of a problem with patterning precision of layers due to warping of the mask and a problem of high film-forming costs caused by the necessity of a large vacuuming apparatus, it has been considered that a manufacturing process for an organic EL device with a large screen by the use of the vacuum vapor deposition method is very difficult.

On the other hand, a coating method has been examined as a method for forming organic EL layers. The coating method is a method in which ink containing components for forming an organic EL layer, that is, ink containing an organic EL material, is applied to a base member, and then the resultant is cured by a drying process or the like to form the corresponding layer. As the coating method, for example, an ink-jet method (droplet coating method) and a nozzle printing method (liquid column coating method) are proposed (see Patent Document 1). In accordance with the ink-jet method, the applied amount of the organic EL material can be precisely controlled, and a precise positioning control process in the order of several microns can be carried out; therefore, the ink-jet method has been developed as a technique for achieving a large-screen organic EL device. The nozzle printing method is a method in which ink is continuously discharged from a nozzle as liquid columns so as to apply the ink onto a base member, and in addition to the same advantages as those of the ink-jet method, the nozzle printing method has an advantage in that clogging hardly occurs in the nozzle hole.

In the formation of an organic EL layer by using a wet process such as the ink-jet method and the nozzle printing method, a method is generally adopted in which a partition wall corresponding to a coating pattern for forming a large number of organic EL elements on a substrate is formed so that an ink coating area is controlled.

### PRIOR ART DOCUMENTS

### PATENT DOCUMENT

[Patent Document 1]: JP2002-75640A

### DISCLOSURE OF THE INVENTION

As the shape of the partition wall, a box-shaped partition wall for use in arranging the respective pixels in a lattice pattern and a stripe-shaped partition wall in parallel with a coating direction, as disclosed in Patent Document 1, have been known.

In the box-shaped partition wall, since ink is applied to each of the pixels, deviations in the applied amount cause deviations in the thickness of the organic EL layer for each of the pixels. In the case of the stripe-shaped partition wall, although deviations in the thickness of the layer in pixels within the same stripe are suppressed, deviations in the thickness of the layer tend to occur between different stripes.

When the organic EL layer is a light emitting layer, the deviations in the layer thickness cause a difference in luminance between different light emitting layers. Reduction in the luminance difference between the pixels forms an important factor on the quality of a display apparatus. Therefore, it is important to reduce deviations in the layer thickness.

An objective of the present invention is to provide a substrate for organic EL devices and an organic EL device that provide a high-quality display apparatus having a reduced luminance difference among the respective pixels.

A substrate for an organic EL device of the present invention is provided with a support substrate on which a plurality of pixel electrode arrays are formed in parallel with each other, and a partition wall composed of stripe partition walls located between each of the pixel electrode arrays along the pixel electrode arrays and a frame partition wall in the form of a rectangle surrounding all of the plurality of pixel electrode arrays, and in this structure, the partition wall partitions a coating area of ink applied on the pixel electrode arrays and a neighboring coating area of ink applied on the pixel electrode array, and notches are located in the stripe partition walls to make the neighboring coating areas communicate with each other. The ink coating area is an area to which ink is applied so as to form one or more organic EL layers including a light emitting layer.

In the substrate for an organic EL device of the present invention, on the support substrate, a plurality of pixel electrode arrays are formed in parallel with each other, and the partition wall that partitions an ink coating area are formed. The partition wall is composed of stripe partition walls formed between the respective pixel electrode arrays and a frame partition wall surrounding all of the plurality of pixel electrode arrays. The partition wall partitions a coating area of ink applied on the pixel electrode arrays and a neighboring coating area of ink applied on the pixel electrode array. Notches are located in the stripe partition walls to make the neighboring coating areas communicate with each other. With this structure, the ink applied to the coating areas is allowed to flow between the communicated coating areas from the area with more applied amount to the other area with less applied amount to be averaged. Therefore, it is possible to suppress deviations in the thickness of the organic EL layer among coating areas (among stripes).

When the nozzle carries out a coating process while moving from one end of the coating area to the other end, or from the other end to the one end, ink waves are generated together with the nozzle movement in the same direction and collide with the frame partition wall. The ink waves collide with the frame partition wall and return while being widened. In this arrangement, in the case when the notch is formed in one end of the stripe partition wall or in each of two ends thereof, the ink is allowed to flow into the neighboring coating area through the notch so that it is possible to accelerate to average the thicknesses of the organic EL layers between the coating areas.

In the case when the notches are alternately formed in one end and the other end in the respective stripe partition walls, upon carrying out, for example, a nozzle printing method, the communication of the coating areas is made in accordance with the coating order of the nozzle that carries out the coating process on the coating area in a winding manner.

In the case when one or more of the notches are placed on an intermediate part between the one end and the other end of the stripe partition wall, the ink wave returned from the frame partition wall is allowed to flow into the neighboring coating area from the notches disposed in the intermediate part.

A pixel defining layer for defining each of the pixel electrodes in the pixel electrode array is preferably placed. Thus, it is possible to suppress the generation of voids between the pixel electrodes that are caused upon application of the ink coating and also to regulate the flowability of the ink. As a result, irregularities in the thickness of the ink coating layer within the coating area can be reduced.

The partition walls are preferably made from an organic material, and the pixel defining layer is preferably made from an inorganic material. With these arrangements, the substrate for an organic EL device can be easily manufactured.

A method of manufacturing the organic EL device of the present invention is provided with the steps of: after applying ink containing an organic EL material to an ink coating area in the substrate used for an organic EL device of the present invention, drying the ink so that an organic EL layer is formed. The organic EL device of the present invention is an organic EL device manufactured by the method of producing the organic EL device of the present invention.

In accordance with the method of manufacturing the organic EL device of the present invention, since ink applied to coating areas is allowed to flow between the communicated coating areas having the same color, the ink can be averaged. Therefore, an organic EL device, in which deviations in the thickness of the organic EL layer among the coating areas (among stripes) can be suppressed, can be manufactured. The organic EL device of the present invention can suppress deviations (among stripes) in the thickness of the organic EL layer among the coating areas.

### BRIEF DESCRIPTION OF THE DRAWINGS

Fig. 1 is a plan view illustrating a substrate for an organic EL device in accordance with embodiment 1 of the present invention.
Fig. 2 is a partial enlarged view illustrating a center portion of the substrate for an organic EL device of Fig. 1.
Fig. 3 is an A-A line cross-sectional view of the substrate for an organic EL device of Fig. 2.
Fig. 4 illustrates movements of a nozzle and a panel (substrate) in a nozzle printing process that is one example of a coating process in an embodiment of the present invention.
Fig. 5 illustrates a track of a nozzle in the nozzle printing process that is one example of a coating process.
Fig. 6 illustrates movements of a nozzle and a panel (substrate) in an ink-jet process that is one example of a coating process in the embodiment of the present invention.
Fig. 7 illustrates an ink application state on a substrate for an organic EL device in accordance with the embodiment of the present invention: Fig. 7(A) is a cross-sectional view illustrating a state immediately after the ink application (before drying), and Fig. 7(B) is a cross-sectional view illustrating a state after the ink has been dried.
Fig. 8 is a plan view that illustrates a substrate for an organic EL device in accordance with embodiment 2 of the present invention.
Fig. 9 is a plan view that illustrates a substrate for an organic EL device in accordance with embodiment 3 of the present invention.
Fig. 10 is a plan view that illustrates a substrate for an organic EL device in accordance with embodiment 4 of the present invention.

### EXPLANATION OF REFERENCE NUMERALS

- 1, 1b to 1d: Substrate for an organic EL device
- 2: Support substrate
- 3: Pixel electrode array
- 31: Pixel electrode
- 4: Pixel defining layer
- 5: Partition wall
- 51: Stripe partition wall
- 51a: Notch
- 52: Frame partition wall
- 521: First frame partition wall
- 522: Second frame partition wall
- 71, 72: Ink
- S1: Coating area
- 20, 21: Nozzle
- Dd: Transporting direction of substrate for organic EL device
- Ip: Track of nozzle
- Nm: Moving direction of nozzle

### MODES FOR CARRYING OUT THE INVENTION

### (Embodiment 1)

Referring to Figs., the following description will discuss a substrate for an organic EL device in accordance with embodiments of the present invention. In the Figures, a scale of each of members is sometimes different from an actual scale.

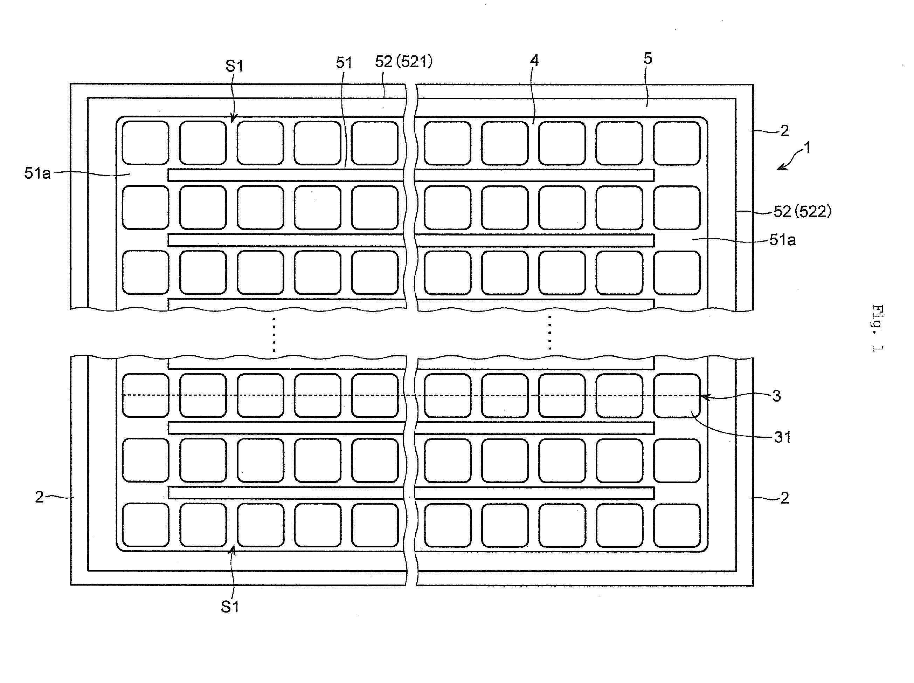

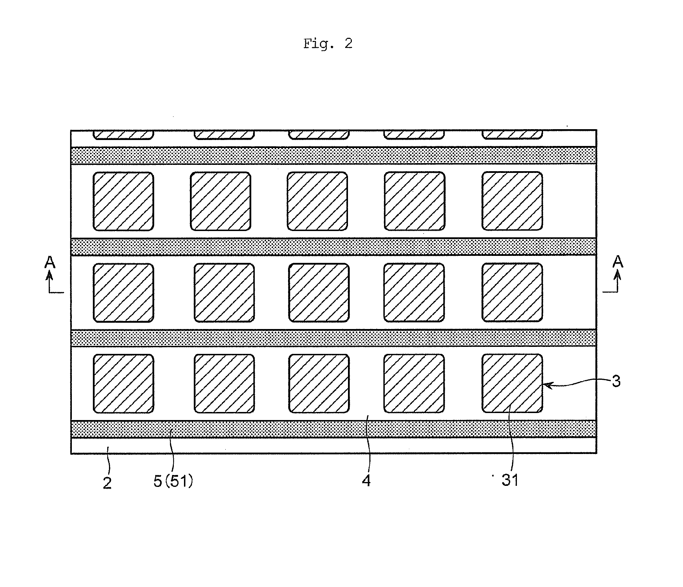

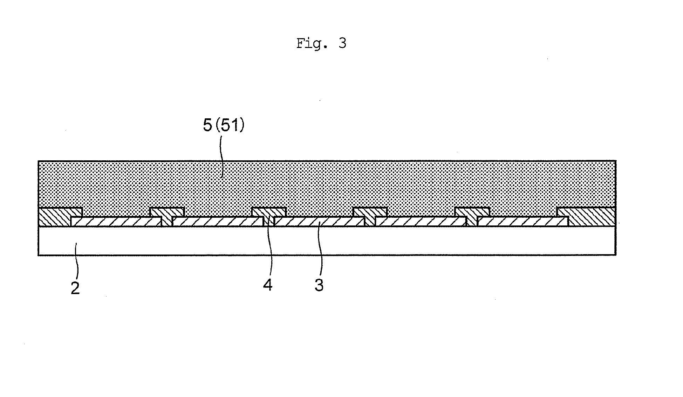

As shown in Figs. 1 to 3, a substrate 1 for an organic EL device in the embodiment of the present invention is a substrate for use in mono-color light emission. The substrate 1 for an organic EL device is provided with a support substrate 2, a plurality of pixel electrode arrays 3 formed on the support substrate 2 in parallel with one another, pixel defining layers 4 for defining pixel electrodes 31 composed of the pixel electrode arrays 3, and partition walls 5 for defining an ink coating area S1 into a stripe pattern so as to form an organic EL layer containing a light emitting layer. Pixels refer to light emission areas defined by the pixel defining layers 4.

As the component material for the support substrate 2, any known material may be used as long as it is chemically stable upon forming electrodes and an organic EL layer. Examples of the support substrate 2 include: a glass substrate, a plastic substrate, a polymer film, a silicon substrate, a metal substrate, and a laminated member of these.

The pixel electrode arrays 3 are electrode arrays composed of pixel electrodes 31 that are linearly aligned regularly. Each of the pixel electrodes 31 is partitioned by pixel defining layers 4. The pixel defining layers 4 are designed to partition the pixel electrodes 31 in the pixel electrode arrays 3. In the present embodiment, the pixel defining layers 4 are disposed so as to surround each pixel electrode 31, and divide the pixel electrodes 31 from one another. On the pixel electrodes 31, one or more organic EL layers including a light emitting layer are formed. At least one layer among the organic EL layers is a light emitting layer, and as the other organic EL layers, a hole transporting layer, an electron blocking layer, etc., which will be described layer, are proposed. The organic EL layer is formed using ink prepared as a solution, a suspension or a colloid dispersion fluid, containing a material for forming an organic EL layer (hereinafter, referred to as "organic EL material") and an ink solvent. In the present specification, the term "solvent" is used as a concept including both of a liquid for use in dissolving an organic EL material and a liquid for use in dispersing the organic EL material, unless otherwise indicated.

The pixel defining layers 4 are disposed for the purposes of defining the light emitting areas and of ensuring a mutual insulating property between the pixel electrodes 31. The pixels electrodes 31 are defined by the pixel defining layers 4 so as to be aligned with constant intervals. By disposing the pixel defining layers 4, the generation of voids among the pixel electrodes 31 that tend to be generated upon application of the ink can be suppressed as well.

The material for the pixel defining layers 4 is preferably an insulator. Examples of the material include: inorganic materials like inorganic oxides such as SiO₂, and inorganic nitrides such as SiN, and organic materials like heat-resistant resin materials such as polyimide and novolak resins, and the inorganic materials are preferably used.

The partition wall 5 is provided with stripe partition walls 51 that are formed along the pixel electrode arrays 3 constituted by pixel electrodes 31 with constant intervals in parallel with one another, in a manner so as to divide the pixel electrode arrays 3 one row by one row, and frame partition walls 52 that divide the coating areas S1 together with the stripe partition walls 51.

In the case of a nozzle printing process to be described later, the stripe partition walls 51 are arranged in parallel with a direction (nozzle scanning direction) in which the ink is continuously applied. Notches 51a are placed on the two ends of each stripe partition wall 51. The ink coating areas S1 are mutually communicated with each other by each notch 51a. In the present embodiment 1, since the notch 51a is disposed on each of the two ends of all the stripe partition walls 51, all the coating areas S1 are allowed to communicate with one another. In the case of an ink-jet process, the stripe partition walls 51 may be arranged in parallel with a direction (nozzle scanning direction) in which the ink is continuously applied, or may be arranged perpendicular to this direction.

The frame partition walls 52, which surround the entire pixel electrode arrays 3, are partition walls to each of which both of one end and the other end of each stripe partition wall 51 are connected. The frame partition walls 52 are formed into a rectangular shape by first frame partition walls 521 that are located on the two sides of each stripe partition wall 51, and formed in parallel with the stripe partition walls 51 and second frame partition walls 522 that are located on the two end sides of each stripe partition wall 51, and formed in a direction perpendicular to the stripe partition walls 51. In the present embodiment 1, the notch 51a is formed on each of the two ends of all the stripe partition walls 51.

The partition walls 5 are disposed so as to avoid ink applied to the respective pixel electrode arrays 3 from being mixed with each other in each coating area S1 between the respective arrays. The height of each partition wall 5 is designed to have an enough height to hold the applied ink.

The partition walls 5 may be formed by an electrically insulating material. Examples of the material include organic materials like insulating resin materials such as polyimide and novolak resins and these materials are preferably used. In order to improve the retaining performance of the applied ink within the coating area, a liquid repellent property for repelling ink may be given to the surface of each partition wall. For example, by subjecting the partition walls 5 to a CF₄ plasma treatment, the partition walls 5 are allowed to have a liquid repellent property.

Referring to Figs., the following description will discuss a method for manufacturing an organic EL device in which the substrate 1 for an organic EL device relating to the present embodiment 1 is used. In the present specification, a laminated article, composed of a pixel electrode 31, an electrode that forms a pair with the pixel electrode 31, and one or more organic EL layers including a light emitting layer sandwiched between these electrodes, is defined as "an organic EL element". A display apparatus having a flat-plate shape on which the organic EL elements are arranged two-dimensionally is defined as "an organic EL device". The "organic EL layer" means a layer made from an organic EL material.

The organic EL device also includes members such as lead wires for electrodes. With respect to the electric wiring, electric circuits or the like, since various known modes may be applied based upon normal knowledge in the technical fields of light emitting elements, display apparatuses, etc., and since these are not directly related to the description of the present invention, the explanations thereof will be omitted.

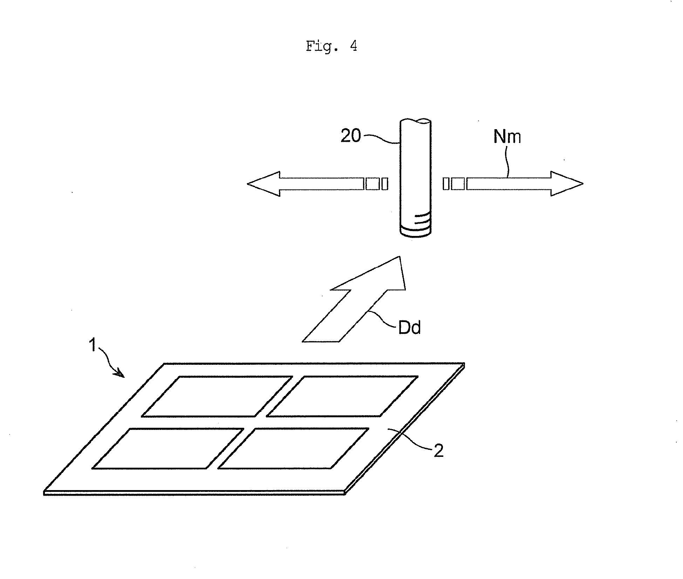

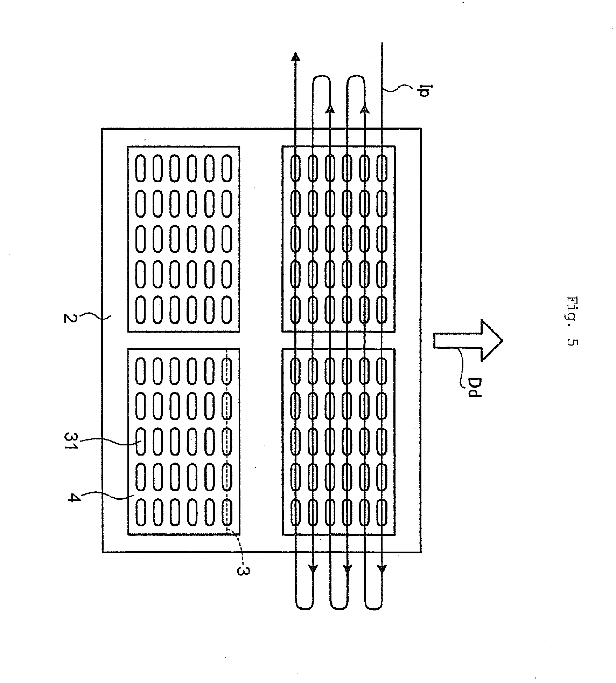

Figs. 4 and 5 illustrate states of an ink applying process by a nozzle printing method, which is one example of the coating method. As shown in Fig. 4, a substrate 1 for an organic EL device, constituted by pixel electrode arrays 3, pixel defining layers 4 and partition walls 5 disposed on a support substrate 2, is transported in a direction of Dd. From a nozzle 20 of a nozzle printing device (a main body of which is not shown), ink used for forming respective organic EL layers is discharged. The nozzle 20 is reciprocally moved in a direction Nm that is orthogonal to the transporting direction Dd of the substrate 1 for an organic EL device.

In the nozzle printing method, the ink is continuously discharged as liquid columns in a non-intermittent manner. The nozzle printing device can continuously discharge ink as liquid columns from a fine nozzle.

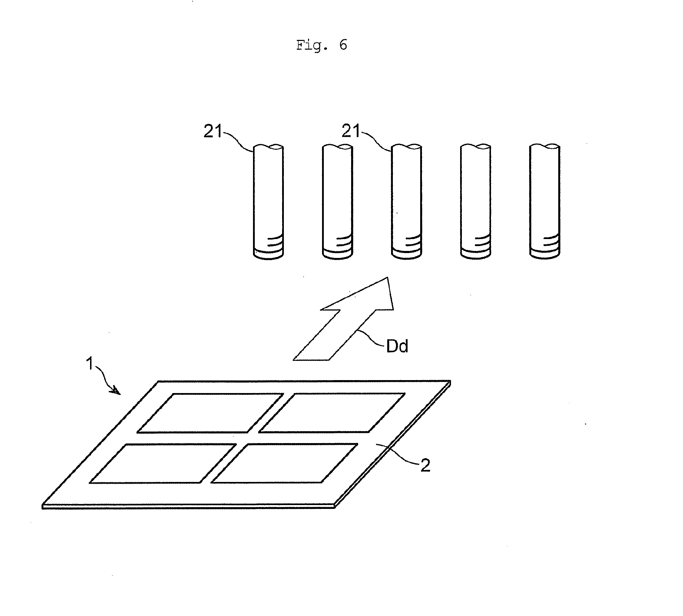

Fig. 6 illustrates states of ink applying process by an ink-jet method, which is one example of the coating method. In the same manner as in Fig. 5, a substrate 1 for an organic EL device is constituted by pixel electrode arrays 3, pixel defining layers 4 and partition walls 5 that are disposed on a support substrate 2, and these are omitted from the drawing. As shown in Fig. 6, the substrate 1 for an organic EL device is transported in a direction of Dd. From a plurality of nozzles 21 of an ink-jet device (a main body of which is not shown), ink used for forming respective organic EL layers is discharged. In Fig. 6, the coating direction by the ink jet is perpendicular to the direction of the pixel electrode arrays 3; however, the coating direction may be made in parallel with the direction of the pixel electrode arrays 3.

In the ink jet method, the ink is continually discharged as liquid droplets in an intermittent manner. The ink-jet device can continually discharge ink droplets from fine nozzles.

The ink to be used is a solution, a suspension or a colloid solution containing a material for forming an organic EL layer, such as a hole transporting layer, an electron-blocking layer, and a light emitting layer (hereinafter, referred to as "organic EL material") and an ink solvent. As described earlier, in the present specification, the term "solvent" is used as a concept including both of a liquid for use in dissolving an organic EL material and a liquid for use in dispersing the organic EL material, unless otherwise indicated.

The ink solvent is selected on demand depending on conditions, such as the solubility and the affinity to the substrate of an organic EL material. The ink solvent needs to preferably satisfy various desirable requirements for the ink solvent such as its volatile characteristic, the solubility or the dispersibility, or the like of the organic EL material. Preferable examples of the ink solvent include: one kind selected from the group consisting of water, an alcohol solvent, a glycol solvent, an ether solvent, an ester solvent, a chlorine-containing solvent and an aromatic hydrocarbon solvent, and a mixture of two or more of these. Examples of the alcohol solvent include: methanol, ethanol, propanol, isopropanol and butanol. Examples of the glycol solvent include: ethylene glycol and propylene glycol. Examples of the ether solvent include: tetrahydrofuran and methoxybenzene. Examples of the ester solvent include: ethyl acetate, and butyl acetate. Examples of the chlorine-containing solvent include: chloroform, chlorobenzene and methylene chloride. Examples of the aromatic hydrocarbon solvent include: toluene, xylene, trimethylbenzene and tetramethylbenzene.

The following description will discuss a coating method by a nozzle printing method in detail as one example of an ink coating method. In the present invention, the coating method is not limited to these methods, and a coating process by the ink-jet method may be used. In the nozzle printing method, as shown in Fig. 4, the substrate 1 for an organic EL device is transported below the nozzle 20, and by allowing the nozzles to reciprocally move in the Nm directions, the nozzles 20 are allowed to move on the substrate of an organic EL device 1 in a manner so as to relatively draw the winding track Ip as shown in Fig. 5. After moving the pixel electrode array 3 by one row in the longitudinal direction, the track Ip of the nozzles 20 is shifted to the next row so that the track moves along a new pixel array 3 in the longitudinal direction. When the substrate 1 for an organic EL device passes below the nozzles 20, ink is discharged from the corresponding nozzle 20 so that the ink is applied thereto.

At this time, in the coating area S1 divided by the partition wall 5 between the rows, since the notches 51a are formed on the two ends of each stripe partition wall 51, the two end portions are mutually associated with each other. Therefore, when the nozzles 20 carry out a coating process while moving one end of the coating area S1 to the other end, or from the other end to the one end, ink waves are generated together with the movement of the nozzles 20 in the same direction and collide with the second frame partition wall 522 of the frame partition wall 52. The ink waves collide with the second frame partition wall 522 and form return waves to be widened. Then, the ink is allowed to flow into a neighboring coating area S1 through the notch 51a from the area having a higher applied amount to the other area having a lower applied amount so that it is possible to accelerate to average the thicknesses of the organic EL layers between the coating areas S1.

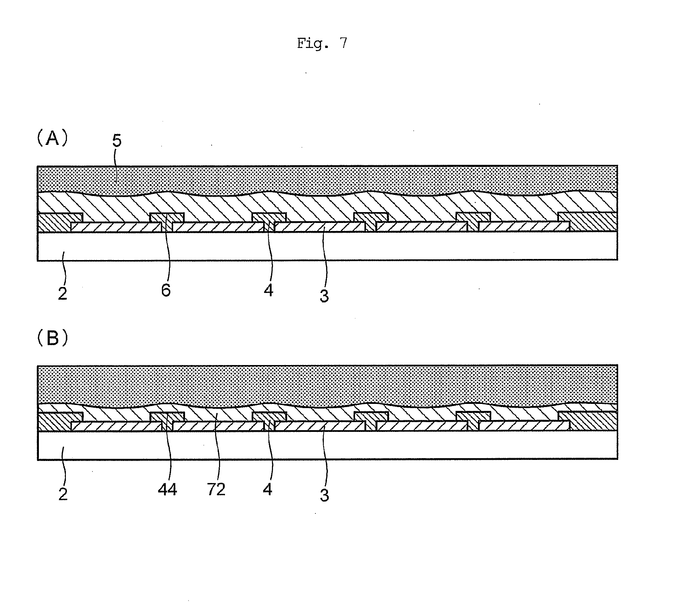

In the nozzle printing process, since the ink is continuously discharged as liquid columns in a non-intermittent manner from the nozzles 20, as shown by the track Ip, the ink is continuously applied in a non-intermittent manner on the pixel electrode 31 and the pixel defining layer 4 located in the longitudinal direction of the pixel electrode array 3. Therefore, as shown in Fig. 7(A) and Fig. 7(B), the ink is applied as non-intermittent lines on the plurality of the pixel electrodes 31 and the pixel defining layers 4 that are aligned in the longitudinal direction of the pixel electrode arrays 3.

Since the partition wall 5 has a sufficient height, the applied ink hardly goes over the partition wall 5 to be mixed with the ink in the neighboring divided area S1. The partition wall 5 may be subjected to a liquid repellent treatment for repelling ink. Upon completion of the ink coating process, the substrate 1 for an organic EL device is put in a prescribed atmosphere in a drying process, and the solvent is evaporated from the ink so as to be cured so that a dried ink layer 72 is formed.

Each of the surfaces of the stripe partition walls 51 and the frame partition walls 52 may have a repellent property for repelling ink so as to desirably hold the ink inside the coating area. As the method for applying the liquid repellency to the surface of each partition wall, a method in which a liquid repellent component is mixed with components forming the stripe partition walls 51 and a method in which a coat film having a liquid repellent property is attached to the surface of the stripe partition walls 51 are proposed. In order to more effectively prevent the ink from going over each stripe partition wall 51 to be mixed with the neighboring divided area S1, the entire surface of each stripe partition wall 51 is preferably allowed to have a liquid repellent property.

In an ink drying process that follows the ink coating process, the solvent is evaporated and removed from the applied ink, and the organic EL material is fixed onto the divided area S1 so that an organic EL layer is obtained. The drying temperature of the ink may be determined on demand depending on the solvent used or the like. An ink baking process may be prepared after the drying process.

Since the amounts of ink applied to the respective coating areas S1 can be averaged in this manner, the thickness of the organic EL layer can be made uniform. Therefore, deviations in the thickness of the organic EL layer can be suppressed in the respective coating areas S1. Since the differences in luminance among the pixels can be consequently made smaller, it is possible to improve the quality of the organic EL device.

In the substrate 1 for an organic EL device relating to the present embodiment 1, the notch 51a is formed on each of all the two ends of the stripe partition walls 51; however, the notch 51a may be installed for every prescribed number of stripe partition walls 51. The notch 51a is designed to have a length corresponding to one pixel as shown in Fig. 1; however, the length may be set to a length corresponding to two or more pixels.

The following description will discuss the structure of an organic EL element to be assembled in an organic EL device, which can be manufactured by the manufacturing method of the present invention in more detail.

The organic EL element is a laminated article constituted by at least a pair of electrodes and organic EL layers including a light emitting layer sandwiched between the electrodes. The organic EL element may include various kinds of organic EL layers in addition to the light emitting layer, as will be described below. With respect to the order of the stacked layers or the like, various modified examples can be proposed.

In the present invention, the organic EL element is not intended to be limited by the following organic EL element. In the method for manufacturing an organic EL element of the present invention, at least one of the organic EL layers is a layer formed using ink through processes including prescribed applying and drying operations, as shown in the above-mentioned embodiment and the like. The other layers may be formed using another method.

In general, each of the organic EL layers forming the organic EL element is an extremely thin film, and various kinds of film-forming methods may be used for forming the layer. In the following explanation, the layer formation is sometimes referred to as "film formation".

In addition to an anode, a light emitting layer and a cathode that are essentially required therein, the organic EL element may have another layer between the anode and the light emitting layer and/or between the light emitting layer and the cathode.

As the anode of the organic EL element, from the viewpoint of producing an element that emits light through the anode, a transparent electrode capable of transmitting light is preferable. As such a transparent electrode, a metal oxide, a metal sulfide and a metal thin film, which have high electric conductivity, is proposed. As the material for the anode, those materials having a high light transmittance are preferably used, and selection may be properly made depending on the organic EL layer, and used. Specific examples of the material forming the anode include a metal oxide selected from the group consisting of indium oxide, zinc oxide, tin oxide, ITO and indium zinc oxide (abbreviated as "IZO"), and a metal or the like selected from the group consisting of gold, platinum, silver, copper and aluminum, and alloys containing at least one kind or more of these metals.

As a material for the cathode, a material having a small work function, capable of easily injecting electrons into the light emitting layer, a material having a high electric conductivity and a material having a high reflectance in a visible light region are preferably used, and selection may be made on demand depending on the organic EL layer, and used. Specific examples of the material for the cathode include: a metal selected from the group consisting of alkali metal, alkali-earth metal, transition metal, metal of III-B family and alloys containing at least one or more kinds of these metals.

The light emitting layer contains an organic compound. Normally, the light emitting layer contains an organic compound (low-molecular weight compound and high-molecular weight compound) that emits fluorescent light or phosphorescent light. The light emitting layer may further contain a dopant material. Examples of the material for forming the light emitting layer include pigment-based materials, metal complex-based materials, polymer-based materials, and dopant-based materials, as following.

Examples of the pigment-based material include: a cyclopendamine derivative, a tetraphenylbutadiene derivative compound, a triphenylamine derivative, an oxadiazole derivative, a pyrazoloquinoline derivative, a distyryl benzene derivative, a distyryl arylene derivative, a pyrrole derivative, a thiophene ring compound, a pyridine ring compound, a perinone derivative, a perylene derivative, an oligothiophene derivative, a trifumanyl amine derivative, an oxadiazole dimer, and a pyrazoline dimmer.

Examples of the metal complex-based material include: a metal complex having a light-emitting function from a triplet excited state, such as an iridium complex, and a platinum complex; and a metal complex having an Al, a Zn, a Be, or the like, or a rare earth metal such as a Tb, an Eu, a Dy as the central metal, with an oxadiazole, a thiadiazole, a phenyl pyridine, a phenyl benzoimidazole or a quinoline structure as the ligand, such as an aluminum quinolinol complex, a benzoquinolinol beryllium complex, a benzoxazol zinc complex, a benzothiazole zinc complex, an azomethyl zinc complex, a porphyrine zinc complex, and an europium complex.

Examples of the polymer-based material include: a polyparaphenylene vinylene derivative, a polythiophene derivative, a polyparaphenylene derivative, a polysilane derivative, a polyacetylene derivative, a polyfluorene derivative, a polyvinyl carbazole derivative, and materials formed by polymerizing the above-mentioned pigment material and metal complex-based material.

The light emitting layer may contain a dopant material so as to improve the light-emitting efficiency or change the light-emitting wavelength. Examples of the dopant material include: a perylene derivative, a coumarin derivative, a rubrene derivative, a quinacridone derivative, a squarylium derivative, a porphyrine derivative, a styryl-based pigment, a tetracene derivative, a pyrazolone derivative, decacyclene, and phenoxazone. The thickness of the light emitting layer is normally from about 2 nm to about 2000 nm.

In the organic EL element, the light emitting layer is normally prepared as one layer, or may be prepared as two layers or more. The light emitting layers of two or more layers may be disposed in contact with one another, or a layer other than the light emitting layer may be interpolated between the light emitting layers.

The following description will discuss layers other than the anode, light emitting layer and cathode in an organic EL element.

As the layers to be formed between the anode and the cathode, a hole injection layer, a hole transporting layer, an electron-blocking layer and the like are proposed. In the case when both of the hole injection layer and the hole transporting layer are formed, the layer closer to the anode is the hole injection layer, and the layer closer to the light emitting layer is the hole transporting layer. In the case when the hole injection layer or the hole transporting layer has a function for blocking the transportation of electrons, these layers may be compatibly used as the electron blocking layer.

The hole injection layer is disposed between the anode and the hole transporting layer, or between the anode and the light emitting layer. As the material for the hole injection layer for use in forming the hole injection layer, not particularly limited, known materials may be used on demand. Examples of the material for the hole injection layer include: a phenylamine-based material, a starburst-type amine-based material, a phthalocyanine-based material, a hydrazone derivative, a carbazole derivative, a triazole derivative, an imidazole derivative and an oxadiazole derivative having an amino group; oxides, such as a vanadium oxide, a tantalum oxide, a tungsten oxide, a molybdenum oxide, a ruthenium oxide and an aluminum oxide; amorphous carbon, polyaniline, and a polythiophene derivative.

As the material for the hole transporting layer for use in forming the hole transporting layer, not particularly limited, and examples thereof include: an aromatic amine derivative, such as N,N'-diphenyl-N,N'- di(3-methylphenyl)4,4'-diaminobiphenyl (TPD) and 4,4'-bis [N-(1-naphthyl)-N-phenylamino]biphenyl)(NPB), polyvinylcarbazole or a derivative thereof, polysilane or a derivative thereof, a polysiloxane derivative having an aromatic amine on its side chain or main chain, a pyrazoline derivative, an arylamine derivative, a stilbene derivative, a triphenyldiamine derivative, polyaniline or a derivative thereof, polythiophene or a derivative thereof, polyarylamine or a derivative thereof, polypyrrole or a derivative thereof, poly(p-phenylenevinylene) or a derivative thereof, or poly(2,5- thienylene vinylene) or a derivative thereof.

As the layers to be formed between the cathode and the light emitting layer, an electron injection layer, an electron transporting layer, a hole-blocking layer and the like are proposed. In the case when both of the electron injection layer and the electron transporting layer are formed, the layer closer to the cathode is the electron injection layer, and the layer closer to the light emitting layer is the electron transporting layer. In the case when the electron injection layer or the electron transporting layer has a function for blocking the transportation of holes, these layers may be compatibly used as the hole blocking layer.

A material for an electron injection layer for use in forming the electron injection layer is properly selected on demand, depending on the kinds of the light emitting layer. Examples of the material for the electron injection layer include: alkali metal, alkali-earth metal, an alloy containing one or more kinds of alkali metal and alkali-earth metal, a metal oxide containing one or more kinds of alkali metal and alkali-earth metal, a halide containing one or more kinds of alkali metal and alkali-earth metal, a carbonate containing one or more kinds of alkali metal and alkali-earth metal, and a mixture of these.

As the material for an electron transporting layer for use in forming the electron transporting layer, not particularly limited, those conventionally known materials may be used. Examples of the material for an electron transporting layer include: an oxadiazole derivative, anthraquinodimethane or a derivative thereof, benzoquinone or a derivative thereof, naphthoquinone or a derivative thereof, anthraquinone or a derivative thereof, tetracyanoanthraquinodimethane or a derivative thereof, a fluorenone derivative, diphenyldicyanoethylene or a derivative thereof, a diphenoquinone derivative, or 8-hydroxyquinoline or a metal complex of its derivative, polyquinoline or a derivative thereof, polyquinoxaline or a derivative thereof, and polyfluorene or a derivative thereof.

As more specific layer structures of the organic EL layers in the organic EL element, the following layer structures are proposed:
a) anode/hole injection layer/hole transporting layer/light emitting layer/electron transporting layer/electron injection layer/cathode
b) anode/hole injection layer/hole transporting layer/light emitting layer/electron transporting layer/cathode
c) anode/hole injection layer/hole transporting layer/light emitting layer/electron injection layer/cathode
d) anode/hole injection layer/hole transporting layer/light emitting layer/cathode
e) anode/hole injection layer/light emitting layer/electron transporting layer/electron injection layer/cathode
f) anode/hole injection layer/light emitting layer/electron transporting layer/cathode
g) anode/hole injection layer/light emitting layer/electron injection layer/cathode
h) anode/hole injection layer/light emitting layer/cathode
i) anode/hole transporting layer/light emitting layer/electron transporting layer/electron injection layer/cathode
j) anode/hole transporting layer/light emitting layer/electron transporting layer/cathode
k) anode/hole transporting layer/light emitting layer/electron injection layer/cathode
l) anode/hole transporting layer/light emitting layer/cathode
m) anode/light emitting layer/electron transporting layer/electron injection layer/cathode
n) anode/light emitting layer/electron transporting layer/cathode
o) anode/light emitting layer/electron injection layer/cathode
p) anode/light emitting layer/cathode
(In this case, "/" indicates that the respective layers are stacked adjacent to each other.)

The organic EL device to be manufactured by the present invention is a device in which a plurality of pixels configured by the organic EL elements are assembled. With respect to the installation of the electric wiring, driving means (such as thin-film transistors), or the like, various conventionally known modes in the production of the organic EL devices can be adopted.

The organic EL device that can be produced by the present invention is applied for a plane light source, a segment display device, a dot matrix display apparatus, and a backlight for a liquid display apparatus.

In order to obtain a plane-state light emission using the organic EL device, an arrangement can be made so that the plane-state anode and cathode are overlapped on each other. Examples of methods to obtain a pattern-shaped light emission includes: a method of placing a mask in which patterned windows are formed on the surface of the plane-state light emitting elements, a method in which an organic substance layer of a non-light emitting portion is formed into an extremely thick portion actually as a non-light emitting portion, and a method in which either of the anode or the cathode or both of the electrodes are formed into a patterned manner. By using any one of these methods, a pattern is formed, with some of the electrodes being disposed so as to be ON/OFF operated independently, whereby a segment-type display apparatus that can display figures and characters as well as simple symbols, etc. can be obtained. In order to obtain a dot-matrix element, a passive matrix substrate in which both of the anode and cathode are formed into stripe shapes and disposed in a manner so as to be orthogonal to each other or an active matrix substrate in which a thin-film transistor is disposed so as to be controlled on a pixel unit basis may be used. By using another method in which light emitting materials having different light emission colors are applied to divided portions or in which a color filter or a fluorescent light conversion filter is used, a partial-color display or a multi-color display can be obtained. These display devices may be used for display apparatuses, such as a computer, a television, a portable terminal, a portable telephone, a car navigation system, and a viewfinder of a video camera.

The plane-state light emitting device is a thin spontaneous light-emitting type device, and preferably used as a plane-state light source for a backlight of a liquid crystal display device or as a plane-state light source for illumination. When a flexible substrate is adopted, a curved-surface light source or display apparatus may be obtained.

### (Embodiment 2)

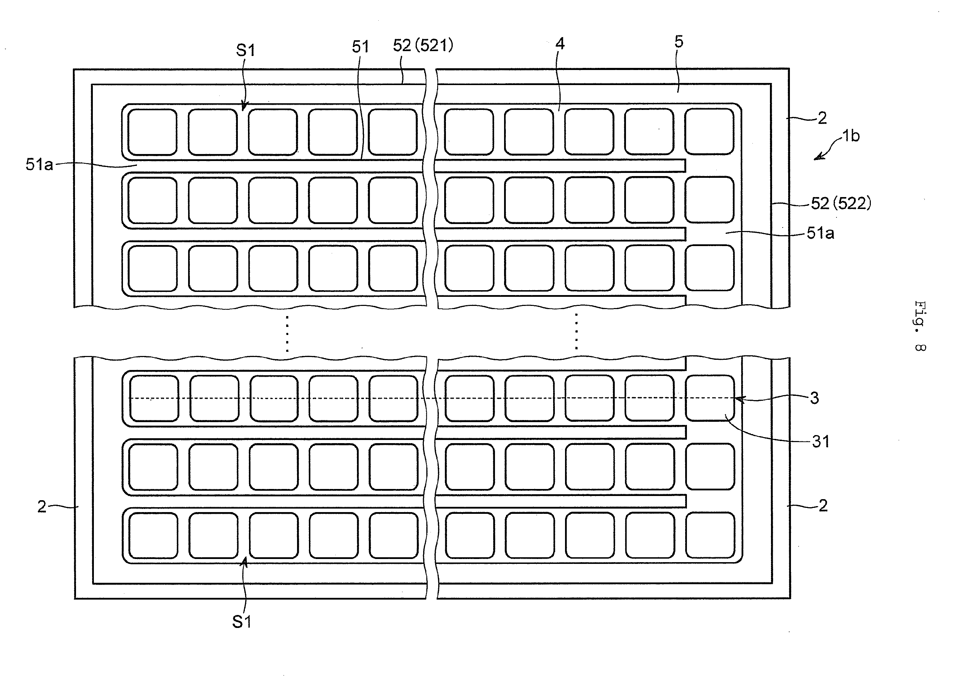

Referring to Fig. 8, the following description will discuss a substrate 1b for an organic EL device in accordance with embodiment 2 of the present invention. In Fig. 8, those members that are the same as those of Fig. 1 are indicated by the same reference numerals, and the description thereof will be omitted.

The substrate 1b for an organic EL device shown in Fig. 8 is used in the case when a light emission color of the light emitting layer is a mono color, and its notch 51a is formed only on one of the ends of each stripe partition wall 51. Neighboring coating areas S1 are communicated with each other only through one end portion side.

In the substrate 1b for an organic EL device, the coating areas S1, each formed into a stripe pattern, are communicated with each other by the notch 51a formed on one end of each stripe partition wall 51 so that the ink for use in forming an organic EL layer is allowed to flow between the communicated coating areas S1 from the area with more applied amount to the other area with less applied amount through the notch 51a. Therefore, it is possible to average the amounts of ink applied to the respective coating areas S1 so that the thickness of the organic EL layer can be made uniform.

### (Embodiment 3)

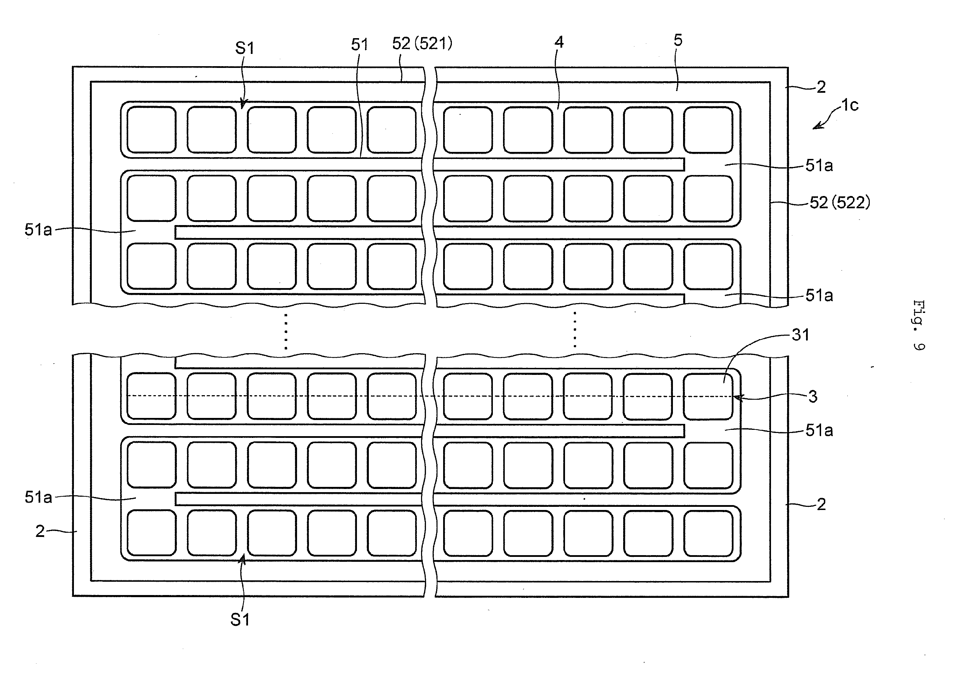

Referring to Fig. 9, the following description will discuss a substrate 1c for an organic EL device in accordance with embodiment 3 of the present invention. In Fig. 9, those members that are the same as those of Fig. 1 are indicated by the same reference numerals, and the description thereof will be omitted.

In the substrate 1c for an organic EL device shown in Fig. 9, between one end portion and the other end portion of each stripe partition wall 51, each of the notches 51a is alternately formed thereon.

Since the notches 51a are formed on the strip partition walls 51 in this manner, communications between the coating areas S1 can be made in accordance with the coating order of the nozzle 20 (see Fig. 5) that carries out a coating process on the coating areas S1 in a winding manner.

### (Embodiment 4)

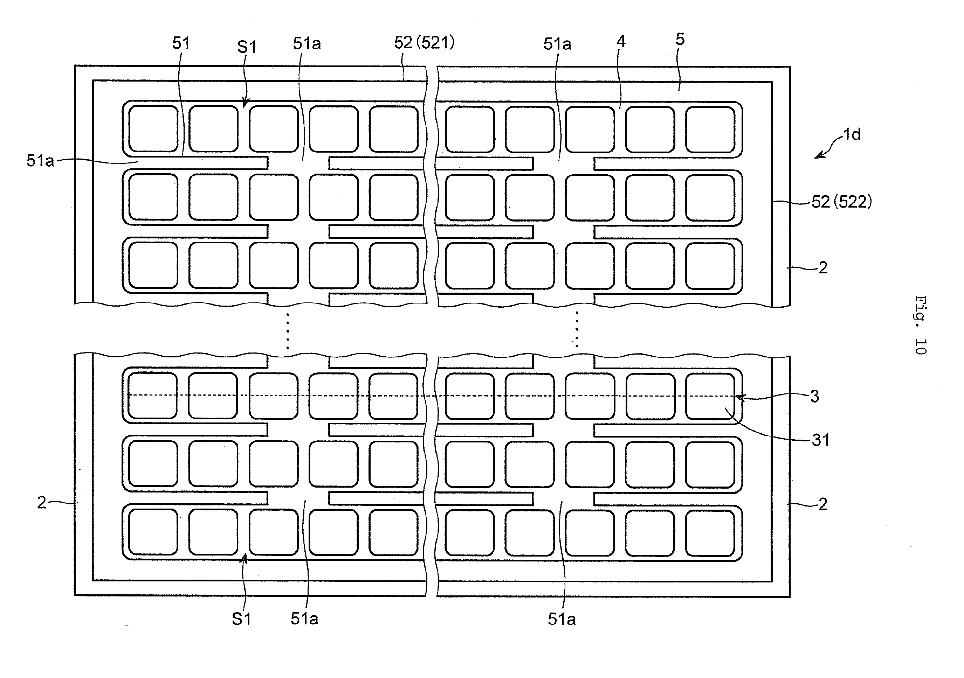

Referring to Fig. 10, the following description will discuss a substrate 1d for an organic EL device in accordance with embodiment 4 of the present invention. In Fig. 10, those members that are the same as those of Fig. 1 are indicated by the same reference numerals, and the description thereof will be omitted.

In the substrate 1d for an organic EL device shown in Fig. 10, one or more notches 51a are formed between one end portion and the other end portion of each stripe pattern wall 51.

In the present embodiment 4, the notches 51a are formed on each stripe partition wall 51 with every prescribed interval.

Since the notch 51a is formed on an intermediate portion of each stripe partition wall 51, ink waves that collide with the second frame partition wall 522 of the frame partition wall 52 are allowed to return to flow into the neighboring coating area S1 through the notch 51a.

In the substrate 1d for an organic EL device relating to the present embodiment 4, as shown in Fig. 10, the notch 51a is formed only on an intermediate portion of each stripe partition wall 51; however, other arrangements may be made by combining the arrangements, in which they are formed on an intermediate portion as well as on the two end portions (substrate 1a for an organic EL element of embodiment 1 (see Fig. 1)), in which they are formed on an intermediate portion as well as on one end portion (substrate 1b for an organic EL element of embodiment 2 (see Fig. 8)), and in which they are formed on an intermediate portion as well as on one end portion or the other end portion alternately (substrate 1c for an organic EL element of embodiment 3 (see Fig. 9).

In the present embodiment 4, notches 51a are formed on each stripe partition wall 51 in an intermediate portion thereof with predetermined intervals; however, one or more notches 51a may be prepared as long as the ink flowability is ensured between mutual neighboring coating areas S1.

### INDUSTRIAL APPLICABILITY

In accordance with the present invention, since applied ink is allowed to flow between coating areas that are communicated with each other by the presence of a notch located in a stripe partition wall, deviations in thickness of organic EL layers between mutually neighboring coating areas can be suppressed. Thus, the luminance difference between pixels is reduced. Therefore, the present invention achieves a high-quality display apparatus.

The substrate for an organic EL device of the present invention is preferably applied to a manufacturing process for an organic EL device when the organic EL device is formed by ink coating such as a nozzle printing method and an ink-jet method. By using the substrate, since deviations in the thickness of the organic EL layer are suppressed and since a high-quality organic EL device with little difference in luminance between pixels is obtained, the present invention is very useful from the industrial view point.

## Claims

1. A substrate used for an organic EL device comprising:
a support substrate on which a plurality of pixel electrode arrays are formed in parallel with each other and
a partition wall composed of stripe partition walls located between each of the pixel electrode arrays along the pixel electrode arrays and a frame partition wall in the form of a rectangle surrounding all of the plurality of pixel electrode arrays,
wherein
the partition wall partitions a coating area of ink applied on the pixel electrode arrays and a neighboring coating area of ink applied on the pixel electrode array, and
notches are located in the stripe partition walls to make the neighboring coating areas communicate with each other.

2. The substrate used for an organic EL device according to Claim 1, wherein the notches are located in a part of one end or both ends of the stripe partition walls.

3. The substrate used for an organic EL device according to Claim 1, wherein the notches are located in a part of one end and the other end alternately in each of the stripe partition walls.

4. The substrate used for an organic EL device according to any one of Claims 1 to 3, wherein one or more notches are located in an intermediate part between the part of one end and the other end of the stripe partition walls.

5. The substrate used for an organic EL device according to any one of Claims 1 to 4, wherein pixel defining layers partitioning each pixel electrodes composed of the pixel electrode array are located.

6. The substrate used for an organic EL device according to Claim 5, wherein the partition wall is made of an organic material and the pixel defining layer is made of an inorganic material.

7. A method of manufacturing an organic EL device comprising a step of:
applying ink comprising an organic EL material on the coating area of ink in the substrate used for an organic EL device according to any one of Claims 1 to 6, and then drying the ink to form an organic EL layer.

8. An organic EL device manufactured by the method according to Claim 7.
